# EUROPEAN PATENT SPECIFICATION

(11) **EP 4 410 064 B1**
(45) Date of publication and mention of the grant of the patent: **17.06.2026**
(21) Application number: 22772873.0
(22) Date of filing: 31.08.2022
(51) Int. Cl.: H05K 7/14

(54) **AN ARRANGEMENT FOR CONNECTING AN ELECTRICAL SYSTEM TO ELECTRONIC UNITS**
ANORDNUNG ZUM VERBINDEN EINES ELEKTRISCHEN SYSTEMS MIT ELEKTRONISCHEN EINHEITEN
AGENCEMENT POUR CONNECTER UN SYSTÈME ÉLECTRIQUE À DES UNITÉS ÉLECTRONIQUES

(30) Priority: 30.09.2021 SE 2151197
(43) Date of publication of application: 07.08.2024
(73) Proprietor: ALSTOM Holdings, 93400 Saint-Ouen-sur-Seine (FR)
(72) Inventor: GUMMERSON, Paul, 722 44 Västerås (SE); BIRD-RADOLOVIC, Ian, 723 55 Västerås (SE)
(74) Representative: Bjerkén Hynell KB
(86) International application number: PCT/EP2022/074224
(87) International publication number: WO 2023/052023

(56) References cited:
- US-A1- 2013 107 452

## Description

### TECHNICAL FIELD OF THE INVENTION

The present invention relates to an arrangement for connecting an electrical system to electronic units of a system for control of electrical devices.

By way of example it may be mentioned that such electrical devices may be converters arranged on a track-bound vehicle and the electronic units are then the electronic components controlling the operation of the converters, that is controlling the semiconductor devices, such as IGBTs, of the converters. The electrical system does in such a case include different sensors delivering information about levels of voltages, temperatures and more to the electronic units to consider when carrying out said control. In this particular example one and the same arrangement may preferably be used for such a connection of the electrical system on board the track-bound vehicle to electronic units of a system for control of all converters on board the vehicle, such as line converter, motor converter and auxiliary converter. Although this particular use of an arrangement of this type will be mainly discussed and explained in this disclosure it is pointed out that the invention is certainly not restricted thereto but extends to cover arrangements for connecting any electrical system to any type of electronic units of a system for control of any type of electrical devices, not only converters.

### BACKGROUND ART

Known arrangements of the type defined above use a variety of cable harnesses and connectors for realizing the interface between the electrical system and the electronic units of the system for control of the electrical devices, such as converters. Several disadvantages are adhered to this way of realizing said interface. It is labour intensive, expensive and space consuming, and it results in limited reliability due to many physically connected serial connections. US 2013/0107452 discloses a cooling system configured to cool a circuit board assembly arranged inside a cabinet.

### SUMMARY OF THE INVENTION

The object of the present invention is to provide an arrangement of the type defined in the introduction addressing the problems mentioned above of such arrangements already known.

This object is according to the invention obtained by providing such an arrangement with the features listed in the characterizing part of appended patent claim 1.

Thus, said cable harnesses and connectors are according to the invention replaced by a plate having on a first side thereof at least one first side connector configured to receive a connector of said electrical system and an opposite second side thereof formed by a printed circuit board to which said at least one first side connector connects and whereas the printed circuit board is provided with at least one second side connector designed for connection of members controlling said electronic units thereto. This means that the intermediate connections realizing said interface are implemented by using printed circuit board technology and accordingly through a complete printed circuit board solution. The need for intermediate connectors cables is removed and means of very simple system integration of electronic control units is provided which essentially resolves all the disadvantages mentioned above of the known arrangements.

According to an embodiment of the invention the arrangement has at least one said second side connector configured to provide connections to said members in the form of printed circuit boards. This means that said electronic units may be integrated in said members in the form of printed circuit boards connecting to the printed circuit board on the plate and by that to the first side connector and to said electrical system through said second side connector. This constitutes a remarkably simplified, space saving design with a possibility to improved operation reliability and status check simplicity facilitating tracing and taking care of faults.

According to another embodiment of the invention the arrangement has at least one said first side connector configured to be able to receive signals from sensors of a said electrical system. This means that sensors of electrical systems may be directly connected to said at least one first side connector and by that to the printed circuit board on the second side of said plate. According to another embodiment of the invention the arrangement has at least one said first side connector configured to be able to receive signals from a communication system, such as using Ethernet or CAN. The arrangement according to the invention does by this provide communication interfaces without the need of intermediate connector cables conventionally used for that sake.

According to another embodiment of the invention the arrangement has at least one said first side connector configured to receive feed of electric energy to said electronic units from a source of electric energy. This means that electric energy needed for the operation of said electronic units may be transferred from the electrical system through the interface provided by the design of said plate with components so that a number of separate cables for that may be omitted. This means for an electrical system on board a track-bound vehicle that electric energy from electric batteries of the vehicle may be provided to the electronic units through the arrangement, which constitutes another embodiment of the invention.

According to the invention the arrangement comprises a rack having a rear wall member with an internal wall formed by said second side of said plate, the rear wall member has a cover with one or more recesses for external access of said at least one first side connector, and the cover is configured to seal around said at least one first side connector to protect the at least one second side connector and members to be connected thereto. Different measures, such as establishing and changing connections, relating to the arrangement will be easy to carry out thanks to the accessibility of the at least one first connector outside said cover while maintaining protection of the interior of the rack with printed circuit board and connectors on the second side of the plate. The cover is an IP65 classed cover providing an Ingress Protection of the interior of the rack including said at least one second side connector and members to be connected thereto. Full IP65 protection is established once the cover is placed inside or in connection with any frame or box, such as a converter box.

According to another embodiment of the invention said rack has a box-like character with an opening on a front side thereof configured to allow said at least one second side connector to be accessible from outside of the rack. This means that members, such as realized through printed circuit boards, configured to control said electronic devices may easily be introduced into and taken out of the rack box.

According to another embodiment of the invention said at least one second side connector is configured to be connected to members controlling electronic units for control of electrical devices in the form of converters. This constitutes a preferred use of an arrangement according to the invention since conventional arrangements for this have a high number of cable harnesses and connectors which may here be avoided.

According to another embodiment of the invention the arrangement comprises a plurality of said first side connectors and/or a plurality of said second side connectors.

According to another embodiment of the invention the arrangement is configured to connect an electrical system on board a track-bound vehicle to electronic units of a system for control of converters arranged on the vehicle. The space available on a track-bound vehicle is limited, so is the possibility to reach different equipment thereof, making an arrangement according to the invention particularly advantageous when having this design.

The invention also relates to a converter box and a track-bound vehicle according to the appended claims directed thereto.

Further advantages as well as advantageous features of the invention will appear from the following description of an embodiment of the invention.

### BRIEF DESCRIPTION OF THE DRAWINGS

With reference to the appended drawings, below follows a specific description of an embodiment of the invention cited as an example. In the drawings:
- Fig 1: is a rear view on the first side of a plate of an arrangement according to an embodiment of the present invention,
- Fig 2: is a front view on the second side of the plate shown in Fig. 1,
- Fig 3: is a perspective view from the front side of the arrangement according to the embodiment of the invention,
- Fig 4: is a rear view of the arrangement shown in Fig. 3, and
- Fig 5: is a simplified perspective view of a converter box according to the present invention including an arrangement according to Fig 3 and arranged on a track-bound vehicle.

### DETAILED DESCRTIPTION OF AN EMBODIMENT OF THE INVENTION

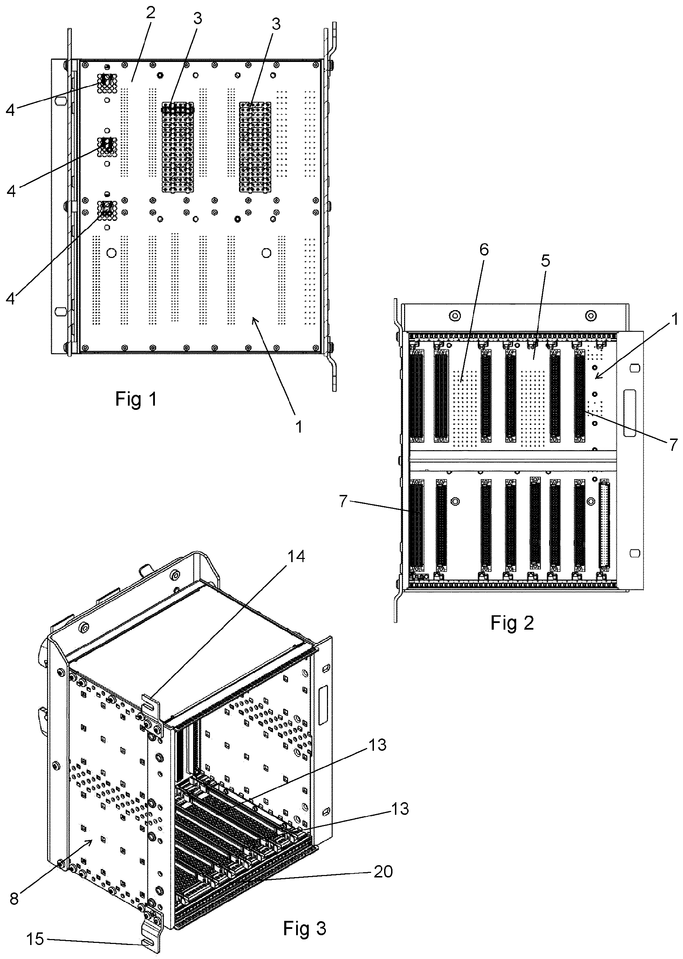

Since the present invention is particularly suited for being used in track-bound vehicles it will hereinafter be disclosed mainly for that application. Reference is made in parallel to Figs 1-4 when now describing the structure of an arrangement for connecting an electrical system to electronic units of a system for control of electrical devices according to an embodiment of the invention.

The arrangement has a plate 1 having on a first side 2 thereof, which here is formed by a printed circuit board, connectors 3, 4 configured to receive a connector each of said electrical system, which here includes different sensors, such as temperature sensors and for instance DC voltage sensors. Communication systems, such as using Ethernet, RS485, MVB and CAN, may also be connected to these first side connectors 3, 4. This is also the case for vehicle batteries with voltages up to 168V DC for feeding electric energy to said electronic units.

The plate 1 has an opposite second side 5 thereof shown in Fig 2 formed by a printed circuit board 6, which may be divided into a plurality of separate parts, to which the first side connectors 3, 4 connect and which is provided with a plurality of connectors 7 designed for connection of members, here in the form of printed circuit boards, for control of said electronic units thereto. Thus, the plate 1 is formed by a printed circuit board.

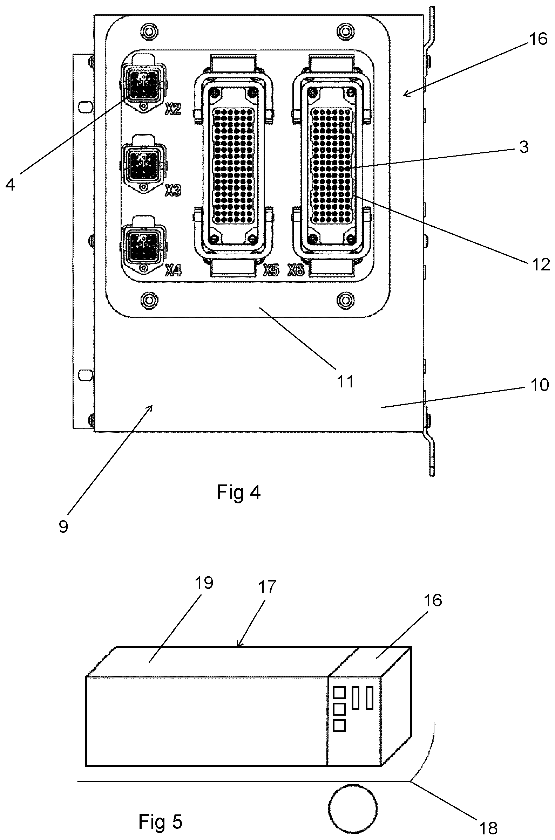

Fig 4 shows how the arrangement comprises a rack 8 having a rear wall member 9 being removed in Fig 1 for showing the first side of the plate 1 and which has an internal wall formed by the second side 5 of the plate. The rear wall member 9 has a cover 10 with a gasket 11 with recesses 12 allowing the first side connectors 3, 4 to be directly accessible from the outside while maintaining an Ingress Protection IP65 of the interior of the rack including the printed circuit board 6, second side connectors 7 and members to be connected to them.

Fig 3 shows how a bottom 20 of the rack is provided with guide rails 13 assisting printed circuit boards for control of the electronic units to be properly inserted into the rack interior to reach and connect to the second side connectors 7. The rack has also a top bracket 14 and a bottom bracket 15 for fastening the rack to a frame or the like.

It is shown in Fig 5 how an arrangement 16 according to the invention shown in Figs 1-4 forms a part of a converter box 17 arranged in a track-bound vehicle 18 for controlling converters arranged on board the vehicle. The other part 19 of the converter box 17 contains inter alia said electronic units for controlling semiconductor devices and rectifying diodes of current valves of the converters. Full IP65 protection may then be established once the rack with cover is placed inside the converter box 17.

The invention is of course in no way restricted to the embodiment described above, since many possibilities for modifications thereof are likely to be obvious to one skilled in the art without having to deviate from the scope of the invention defined in the appended claims.

## Claims

1. An arrangement for connecting an electrical system to electronic units of a system for control of electrical devices,
the arrangement comprises a plate (1) formed by a printed circuit board having
- on a first side (2) thereof at least one first side connector (3, 4) configured to receive a connector of said electrical system and
- an opposite second side (5) thereof being formed by the printed circuit board (6) to which said at least one first side connector (3, 4) connects and whereas the printed circuit board (6) is provided with at least one second side connector (7) designed for connection of members controlling said electronic units thereto, wherein the intermediate connections between said at least one first side connector and said at least one second side connector realizing an interface between said electrical system to said electronic units are implemented by using printed circuit board technology, **characterized in that** the arrangement comprises a rack (8) having a rear wall member (9) with an internal wall formed by said second side (5) of said plate (1), that the rear wall member (9) has a cover (10) with a gasket (11) with one or more recesses (12) for external access of said at least one first side connector (3, 4), and that the cover (10) is configured to seal around said at least one first side connector (3, 4) to protect the at least one second side connector (7) and members to be connected thereto, wherein said cover (10) is designed to provide IP65 protection of the interior of the rack (8) including the printed circuit board (6), said at least one second side connector (7), and members to be connected thereto.

2. An arrangement according to claim 1, **characterized in that** it has at least one said second side connector (7) configured to provide connections to said members in the form of printed circuit boards.

3. An arrangement according to claim 1 and 2, **characterized in that** it has at least one said first side connector (3, 4) configured to be able to receive signals from sensors of a said electrical system.

4. An arrangement according to any of the preceding claims, **characterized in that** it has at least one said first side connector (3, 4) configured to be able to receive signals from a communication system, such as using Ethernet or CAN.

5. An arrangement according to any of the preceding claims, **characterized in that** it has at least one said first side connector (3, 4) configured to receive feed of electric energy to said electronic units from a source of electric energy.

6. An arrangement according to any of the preceding claims, **characterized in that** said rack (8) has a box-like character with an opening on a front side thereof configured to allow said at least one second side connector (7) to be accessible from outside of the rack.

7. An arrangement according to any of the preceding claims, **characterized in that** said at least one second side connector (7) is configured to be connected to members controlling electronic units for control of electrical devices in the form of converters.

8. An arrangement according to any of the preceding claims, **characterized in that** it comprises a plurality of said first side connectors (3, 4) and/or a plurality of said second side connectors (7).

9. An arrangement according to any of the preceding claims, **characterized in that** it is configured to connect an electrical system on board a track-bound vehicle (18) to electronic units of a system for control of converters arranged on the vehicle.

10. An arrangement according to claims 5 and 9, **characterized in that** it has at least one said first side connector (3, 4) configured to receive electric energy from electric batteries of the vehicle.

11. A converter box, **characterized in that** it has an arrangement (16) according to any of the preceding claims enclosed therein.

12. A track-bound vehicle provided with an arrangement according to any of claims 1 - 10.

## Patentansprüche

1. Anordnung zum Verbinden eines elektrischen Systems mit elektronischen Einheiten eines Systems zur Steuerung/Regelung elektrischer Vorrichtungen,
wobei die Anordnung eine durch eine Leiterplatte gebildete Platte (1) umfasst mit
- wenigstens einem erste-Seite-Verbinder (3, 4) an einer ersten Seite derselben, konfiguriert zur Aufnahme eines Verbinders des elektrischen Systems und
- einer entgegengesetzten zweiten Seite (5) derselben, gebildet durch die Leiterplatte (6), mit welcher der wenigstens eine erste-Seite-Verbinder (3, 4) verbunden ist, und wohingegen die Leiterplatte (6) mit wenigstens einem zweite-Seite-Verbinder (7) bereitgestellt ist, gestaltet zum Verbinden von die elektronischen Einheiten steuernden/regelnden Elementen damit, wobei die eine Schnittstelle zwischen dem elektrischen System mit den elektronischen Einheiten realisierenden Zwischenverbindungen zwischen dem wenigstens einen erste-Seite-Verbinder und dem wenigstens einen zweite-Seite-Verbinder durch Verwendung von Leiterplattentechnologie implementiert sind, **dadurch gekennzeichnet, dass** die Anordnung ein Gestell (8) mit einem Rückwandelement (9) mit einer durch die zweite Seite (5) der Platte (1) gebildeten Innenwand umfasst, dass das Rückwandelement (9) eine Abdeckung (10) mit einer Dichtung (11) mit einer oder mehreren Ausnehmungen (12) für einen externen Zugang des wenigstens einen erste-Seite-Verbinders (3, 4) aufweist, und dass die Abdeckung (10) dazu ausgebildet ist, um den wenigstens einen erste-Seite-Verbinder (3, 4) herum abzudichten, um den wenigstens einen zweite-Seite-Verbinder (7) und mit diesem zu verbindende Elemente zu schützen, wobei die Abdeckung (10) dazu ausgebildet ist, einen IP65-Schutz des Innenraums des Gestells (8) bereitzustellen, umfassend die Leiterplatte (6), den wenigstens einen zweite-Seite-Verbinder (7) und damit zu verbindende Elemente.

2. Anordnung nach Anspruch 1, **dadurch gekennzeichnet, dass** diese wenigstens einen der zweite-Seite-Verbinder (7) zum Bereitstellen von Verbindungen mit den Elementen in der Form von Leiterplatten konfiguriert aufweist.

3. Anordnung nach Anspruch 1 oder 2, **dadurch gekennzeichnet, dass** diese wenigstens einen der ersten-Seite-Verbinder (3, 4) geeignet zum Empfangen von Signalen von Sensoren des elektrischen Systems konfiguriert aufweist.

4. Anordnung nach einem der vorangehenden Ansprüche, **dadurch gekennzeichnet, dass** diese wenigstens einen der ersten-Seite-Verbinder (3, 4) geeignet zum Empfangen von Signalen von einem Kommunikationssystem konfiguriert aufweist, wie die Verwendung von Ethernet oder CAN.

5. Anordnung nach einem der vorangehenden Ansprüche, **dadurch gekennzeichnet, dass** diese wenigstens einen der ersten-Seite-Verbinder (3, 4) geeignet zum Empfangen der Zufuhr elektrischer Energie zu den elektrischen Einheiten von einer Quelle elektrischer Energie konfiguriert aufweist.

6. Anordnung nach einem der vorangehenden Ansprüche, **dadurch gekennzeichnet, dass** das Gestell (8) eine kastenartigen Gestalt mit einer Öffnung an einer Vorderseite davon aufweist, konfiguriert zum Ermöglichen, dass auf den wenigstens einen zweite-Seite-Verbinder (7) von außerhalb des Gestells zugegriffen werden kann.

7. Anordnung nach einem der vorangehenden Ansprüche, **dadurch gekennzeichnet, dass** der wenigstens eine zweite-Seite-Verbinder (7) dazu konfiguriert ist, mit elektronische Einheiten steuernden/regelnden Elementen zum Steuern/Regeln der elektrischen Vorrichtungen in der Form von Wandlern verbunden zu werden.

8. Anordnung nach einem der vorangehenden Ansprüche, **dadurch gekennzeichnet, dass** diese eine Mehrzahl von erste-Seite-Verbindern (3, 4) und/oder eine Mehrzahl von zweite-Seite-Verbindern (7) umfasst.

9. Anordnung nach einem der vorangehenden Ansprüche, **dadurch gekennzeichnet, dass** diese dazu konfiguriert ist, ein elektrisches System an Bord eines schienengebundenen Fahrzeugs (18) mit elektronischen Einheiten eines Systems zum Steuern/Regeln von an dem Fahrzeug vorgesehenen Wandlern zu verbinden.

10. Anordnung nach den Ansprüchen 5 und 9, **dadurch gekennzeichnet, dass** diese wenigstens einen der erste-Seite-Verbinder (3, 4) zum Empfangen elektrischer Energie von elektrischen Batterien des Fahrzeugs konfiguriert aufweist.

11. Wandlerkasten, **dadurch gekennzeichnet, dass** dieser eine darin eingeschlossene Anordnung (16) nach einem der vorangehenden Ansprüche aufweist.

12. Schienengebundenes Fahrzeug, ausgestattet mit einer Anordnung nach einem der Ansprüche 1-10.

## Revendications

1. Agencement pour connecter un système électrique un système électrique à des unités électroniques d'un système de commande de dispositifs électriques,
l'agencement comprend une plaque (1) formée par une carte de circuit imprimé présentant
- sur un premier côté (2) de celui-ci au moins un premier connecteur latéral (3, 4) configuré pour recevoir un connecteur dudit système électrique et
- un second côté opposé (5) de celui-ci étant formé par la carte de circuit imprimé (6) à laquelle ledit au moins un premier connecteur latéral (3, 4) se connecte et, tandis que la carte de circuit imprimé (6) est pourvue d'au moins un second connecteur latéral (7) conçu pour la connexion d'éléments commandant lesdites unités électroniques à celle-ci, dans lequel les connexions intermédiaires entre ledit au moins un premier connecteur latéral et ledit au moins un second connecteur latéral réalisant une interface entre ledit système électrique et lesdites unités électroniques sont mises en œuvre en utilisant une technologie de carte de circuit imprimé, **caractérisé en ce que** l'agencement comprend un bâti (8) présentant un élément de paroi arrière (9) avec une paroi interne formée par ledit second côté (5) de ladite plaque (1), que l'élément de paroi arrière (9) présente un couvercle (10) avec un joint (11) avec un ou plusieurs évidements (12) pour un accès externe audit au moins un premier connecteur latéral (3, 4) et que le couvercle (10) est configuré pour assurer l'étanchéité autour dudit au moins un premier connecteur latéral (3, 4) pour protéger l'au moins un second connecteur latéral (7) et les éléments à connecter à celui-ci, dans lequel ledit couvercle (10) est conçu pour fournir une protection IP65 de l'intérieur du bâti (8) incluant la carte de circuit imprimé (6), ledit au moins un second connecteur latéral (7) et les éléments à relier à ceux-ci.

2. Agencement selon la revendication 1, **caractérisé en ce qu'**il présente au moins un desdits seconds connecteurs latéraux (7) configuré pour fournir des connexions auxdits éléments sous la forme de cartes de circuit imprimé.

3. Agencement selon les revendications 1 et 2, **caractérisé en ce qu'**il présente au moins un desdits premiers connecteurs latéraux (3, 4) configuré pour pouvoir recevoir des signaux provenant de capteurs dudit système électrique.

4. Agencement selon l'une quelconque des revendications précédentes, **caractérisé en ce qu'**il présente au moins un desdits premiers connecteurs latéraux (3, 4) configuré pour être capable de recevoir des signaux provenant d'un système de communication, par exemple en utilisant Ethernet ou CAN.

5. Agencement selon l'une quelconque des revendications précédentes, **caractérisé en ce qu'**il présente au moins un desdits premiers connecteurs latéraux (3, 4) configuré pour recevoir une alimentation en énergie électrique pour lesdites unités électroniques à partir d'une source d'énergie électrique.

6. Agencement selon l'une quelconque des revendications précédentes, **caractérisé en ce que** ledit bâti (8) présente une forme de boîtier avec une ouverture sur un côté avant de celui-ci configurée pour permettre audit au moins un second connecteur latéral (7) d'être accessible depuis l'extérieur du bâti.

7. Agencement selon l'une quelconque des revendications précédentes, **caractérisé en ce que** ledit au moins un second connecteur latéral (7) est configuré pour être connecté à des éléments commandant des unités électroniques pour commander des dispositifs électriques sous la forme de convertisseurs.

8. Agencement selon l'une quelconque des revendications précédentes, **caractérisé en ce qu'**il comprend une pluralité desdits premiers connecteurs latéraux (3, 4) et/ou une pluralité desdits seconds connecteurs latéraux (7).

9. Agencement selon l'une quelconque des revendications précédentes, **caractérisé en ce qu'**il est configuré pour connecter un système électrique à bord d'un véhicule sur rails (18) à des unités électroniques d'un système de commande de convertisseurs agencés sur le véhicule.

10. Agencement selon les revendications 5 et 9, **caractérisé en ce qu'**il comporte ledit au moins un premier connecteur latéral (3, 4) configuré pour recevoir de l'énergie électrique provenant de batteries électriques du véhicule.

11. Boîtier de convertisseur, **caractérisé en ce qu'**il présente un agencement (16) selon l'une quelconque des revendications précédentes logé dans celui-ci.

12. Véhicule sur rails muni d'un agencement selon l'une quelconque des revendications 1 à 10.
